# EUROPÄISCHE PATENTSCHRIFT

(11) **EP 3 682 447 B1**
(45) Veröffentlichungstag und Bekanntmachung des Hinweises auf die Patenterteilung: **18.05.2022**
(21) Anmeldenummer: 18742461.9
(22) Anmeldetag: 16.07.2018
(51) Int. Cl.: G10L 25/93

(54) **VERFAHREN UND VORRICHTUNG ZUM VERARBEITEN EINES SIGNALS**
METHOD AND DEVICE FOR PROCESSING A SIGNAL
PROCÉDÉ ET DISPOSITIF POUR LE TRAITEMENT D'UN SIGNAL

(30) Priorität: 11.09.2017 DE 102017215938
(43) Veröffentlichungstag der Anmeldung: 22.07.2020
(73) Patentinhaber: Robert Bosch GmbH, 70442 Stuttgart (DE)
(72) Erfinder: LEIDICH, Stefan, 71277 Rutesheim (DE); DOESSEL, Kerrin, 70193 Stuttgart (DE); MANSOUR, Ahmad, 71263 Weil Der Stadt (DE)
(86) Internationale Anmeldenummer: PCT/EP2018/069217
(87) Internationale Veröffentlichungsnummer: WO 2019/048116

(56) Entgegenhaltungen:
- JP-A- 2008 165 125
- US-A- 4 357 852
- US-A1- 2009 216 529
- US-B1- 8 693 716

## Beschreibung

### Stand der Technik

In US 2009/0216529 A1 sind eine Vorrichtung und ein Verfahren beschrieben, bei dem ein Mikrophon-Signal zur Spracherkennung verwendet wird, wobei ein Filtern des Mikrophon-Signals in Reaktion auf die Spracherkennung angepasst wird.

In US 8693716 B1 ist eine Hörhilfe mit verbessertem Signal-zu-RauschVerhältnis beschrieben, wobei eine Transferfunktion auf das Audiosignal angewandt wird, deren Grenzfrequenz in Abhängigkeit eines Steuersignals gewählt ist.

Die Erfindung geht von einem Verfahren oder einer Vorrichtung nach Gattung der unabhängigen Ansprüche aus. Gegenstand der vorliegenden Erfindung ist auch ein Computerprogramm.

Die Analyse von Audiosignalen (Schallsignalen) ist wesentlicher Bestandteil von verschiedenen technischen Anwendungen. Die größte Bedeutung kommt aktuell der Spracherkennung (im Sinne von Spracheingabe) zu. Die Audiosignale werden dazu aufgezeichnet, oftmals über das Internet übertragen und auf leistungsfähigen Servern analysiert. Batteriebetriebene Wireless-Sensor-Nodes sind meist nicht in der Lage diese Funktion abzubilden. Die Anforderungen an Wireless-Sensor-Nodes sind in der Regel auch deutlich weniger komplex. Die Fragestellung reduziert sich auf die Erkennung von der Präsenz von Sprache als Wake-Up-Trigger oder auf die Erkennung von speziellen Key-Words als Schlüsselworten, die eine vorbestimmte Reaktion des Sensorknotens auslösen sollen. Die Erkennung von einfachen Schallereignissen (Glasbruch, Klopfen, ...) als Analyse von Geräuschen ist ebenso relevant. Die Klassifizierung dieser Ereignisse ist auch mit den funktionalen Einschränkungen, welcher Embedded Hardware grundsätzlich unterliegt, möglich.

Ein möglicher Ansatz zur Signalverarbeitung sieht die Aufzeichnungen der Mikrofonsignale und die digitale Datenverarbeitung vor. Dieser Ansatz unterliegt jedoch dem Problem, dass das Aufzeichnen von Schallsignalen mit einer Sample-Rate von beispielsweise 8 bis 44 kHz zu einem Stromverbrauch von (abhängig von einer verwendeten Hardware) beispielsweise über 300µA führt. Die resultierende Betriebszeit eines typischen batteriebetriebenen Systems wäre zu kurz. Denkbar ist auch ein Konzept, bei dem das analoge Schallsignal einer Filterbank zu geführt und spektral zerlegt wird. Die jeweilige spektrale Komponente wird gleichgerichtet und mit einem Tiefpassfilter geglättet. Der Tiefpassfilter (fg=16 Hz) bewirkt eine Mittelung und somit effektiv eine Fensterung des Signals (beispielsweise mit einer Fensterbreite von etwa 10 bis 30 ms). Die Filterbank liefert somit einen Feature-Vektor, welcher mit Techniken des maschinellen Lernens bzw. Machine-Learning klassifiziert werden kann. Durch die Verwendung einer Filterbank mit einer Vielzahl von parallelen Filtern erfordert die technische Implementierung des Konzepts beispielsweise ca. 2mm² Chipfläche in einem 90nm-Prozess.

### Offenbarung der Erfindung

Vor diesem Hintergrund werden mit dem hier vorgestellten Ansatz ein Verfahren, weiterhin eine Vorrichtung, die dieses Verfahren verwendet, sowie schließlich ein entsprechendes Computerprogramm gemäß den Hauptansprüchen vorgestellt. Durch die in den abhängigen Ansprüchen aufgeführten Maßnahmen sind vorteilhafte Weiterbildungen und Verbesserungen der im unabhängigen Anspruch angegebenen Vorrichtung möglich.

Der hier vorgestellte Ansatz schafft ein Verfahren gemäß Anspruch 1.

Unter einem Signal kann vorliegend ein Audiosignal verstanden werden. Unter einem Bandpassfilter kann ein (beispielsweise analoges) elektrisches oder elektronisches Filter verstanden, das ausgebildet ist, um spektrale Signalanteile des Signals, die in einem Durchlass-Frequenzbereich liegen, passieren zu lassen und spektrale Signalanteile des Signals, die außerhalb des Durchlass-Frequenzbereichs liegen, zu dämpfen oder zu unterdrücken. Der Bandpassfilter kann im Schritt des Filterns somit derart ausgestaltet bzw. eingestellt sein, dass Signalanteile des Signals, die im ersten (spektralen) Durchlassbereich als Durchlass-Frequenzbereich des Bandpassfilters liegen, nahezu gedämpft das Bandpassfilter passieren können. Unter einem Erwartungswert kann ein Signalparameter verstanden werden, der (zu einem aktuellen Zeitpunkt des eingelesenen Signals) erwartet wird. Hierzu kann der Erwartungswert beispielsweise aus einer Menge von möglichen vordefinierten Werten bzw. Signalparametern aus einem Speicher ausgelesen werden. Die vordefinierten Werte bzw. Signalparameter können beispielsweise Signalamplituden oder Signalintensitäten bzw. Signalenergien des Signals repräsentieren, die das Signal im durch den Durchlass-Frequenzbereich definierten Frequenzbereich des Bandpassfilters aufweist. Die vordefinierten Werte bzw. erwarteten Signalparameter können hierbei im Rahmen von Laborversuchen aufgezeichnet werden und beispielsweise in einer Art Nachschlagtabelle im Speicher abgelegt werden. Unter einem ersten spektralen Durchlassbereich kann ein erster Frequenzbereich verstanden werden, der sich von einem zweiten Frequenzbereich unterscheidet, der den zweiten spektralen Durchlassbereich repräsentiert.

Der hier vorgeschlagene Ansatz bietet basiert auf der Erkenntnis, dass eine technisch sehr einfache und kostengünstige Verarbeitung des Signals dadurch erfolgen kann, dass der Durchlass-Frequenzbereich des Bandpassfilters in Abhängigkeit von in einem Signal auftretenden Signalparametern gesteuert werden kann. Hierdurch lässt sich sehr effizient auch mit einfachen schaltungstechnischen Mitteln die Analyse des Signals, insbesondere eines Audiosignals, durchführen, sodass einfach analysiert werden kann, ob beispielsweise bestimmte Geräusche oder sprachliche Kennworte im Audiosignal auftreten, die sich durch das Auftreten eines erwarteten Signalparameters in einem bestimmten Spektrum des Signals (welches nun durch den Durchlass-Frequenzbereich des Bandpassfilters repräsentiert ist) auszeichnen. Tritt ein solcher erwarteter Signalparameter in dem bestimmten Spektrum des Signals tatsächlich auf, kann nun der Durchlass-Frequenzbereich des Bandpassfilters verändert werden, sodass bei einer wiederholten Ausführung der Schritte des Verfahrens nun eine Analyse eines Signalanteils in einem anderen spektralen Bereich erfolgen kann. Der hier vorgeschlagene Ansatz bietet somit den Vorteil, bei einer bekannten Abfolge von erwarteten Signalparametern aus unterschiedlichen Frequenzbereichen mit einer technisch sehr einfachen Struktur durch den Wechsel der Spektralbereiche bzw. Frequenzbereiche, aus denen zu untersuchenden Signalanteilen herausgegriffen werden, vorbestimmte Signalmuster einfach erkennen zu können. Diese vorbestimmten Signalmuster können beispielsweise, wie vorstehend bereits genannt, bestimmte Geräusche oder eine menschliche Sprache darstellen, die vorbestimmte Schlüsselworte sagt. Der hier vorgestellte Ansatz ermöglicht somit die effiziente Signalverarbeitung ohne die Verwendung einer komplexen Hardwarestruktur, sodass beispielsweise auch einfach aufgebaute und autonom arbeitende Sensorknoten eine solche Verarbeitung des Signals über eine ausreichend lange Zeitdauer durchführen können.

Besonders vorteilhaft ist eine Ausführungsform des hier vorgeschlagenen Ansatzes, bei der im Schritt des Auswertens als Erwartungswert ein Wert verwendet wird, der eine Signalintensität des Signals im ersten spektralen Durchlassbereich repräsentiert. Eine Signalintensität kann hierbei beispielsweise eine Signalamplitude oder eine Signalenergie sein, die das Signal in demjenigen Frequenzbereich aufweist, der dem ersten spektralen Durchlassbereich entspricht. Eine solche Ausführungsform des hier vorgeschlagenen Ansatzes bietet den Vorteil, eine technisch sehr einfache Verarbeitung des Signals unter Verwendung des Erwartungswertes, beispielsweise in der Form eines Vergleichs des Analog-Digital-Filtersignals oder eines davon abgeleiteten Wertes mit dem Erwartungswert vornehmen zu können.

Gemäß einer weiteren Ausführungsform des hier vorgeschlagenen Ansatzes kann im Schritt des Ansteuerns der Durchlass-Frequenzbereich des Bandpassfilters nicht verändert werden, wenn im Schritt des Auswertens ermittelt wurde, dass das Analog-Digital-Filtersignal nicht in einer vorbestimmten Beziehung zu dem Erwartungswert steht. Eine solche Ausführungsform des hier vorgeschlagenen Ansatzes bietet den Vorteil, dass die detailliertere Verarbeitung beziehungsweise Analyse des Signals in nachfolgenden Verfahrensschritten erst dann aktiviert bzw. weiterverfolgt wird, wenn ein dem Erwartungswert entsprechender Signalanteil in dem ersten Durchlassbereich erkannt wurde. Solange also kein erwarteter Signalanteil im ersten Durchlassbereich auftritt, wird das Signal in nachfolgenden Verfahrensschritten weiterhin dahingehend untersucht, ob im ersten spektralen Durchlassbereich ein dem Erwartungswert entsprechender Signalanteil auftritt. Auf diese Weise lässt sich die Komplexität bei der Verarbeitung des Signals reduzieren, da lediglich nach einem vorbestimmten Signalanteil in einem bestimmten Frequenzbereich des Signals gesucht wird und andere im Signal auftretende Signalanteile nicht weiter berücksichtigt werden.

Günstig ist weiterhin eine Ausführungsform des hier vorgeschlagenen Ansatzes, bei der die Schritte des Einlesens, Filterns, Analog-digital-Wandelns, Auswertens und Ansteuerns wiederholt ausgeführt werden, wobei im wiederholt ausgeführten Schritt des Auswertens das Analog-Digital-Filtersignal zum Erhalt eines weiteren Steuersignals unter Verwendung eines weiteren Erwartungswertes ausgewertet wird, der sich vom Erwartungswert unterscheidet und der einen erwarteten Signalparameter des Signals repräsentiert, insbesondere wobei im wiederholt ausgeführten Schritt des Ansteuerns der Bandpassfilter in Abhängigkeit von dem weiteren Steuersignal angesteuert wird, um den Durchlass-Frequenzbereich des Bandpassfilters von dem zweiten spektralen Durchlassbereich zu dem ersten oder einem dritten spektralen Durchlassbereich zu verändern. Eine solche Ausführungsform des hier vorgeschlagenen Ansatzes bietet den Vorteil, im zeitlichen Ablauf das Signal zuerst nach dem Auftreten von Signalanteilen im ersten spektralen Durchlassbereich hin durchsuchen zu können und nachfolgend das Signal nach einem Auftreten von Signalanteilen im zweiten spektralen Durchlassbereich hin durchsuchen zu können. Auf diese Weise kann mit der vorgestellten technisch einfachen Struktur unter Verwendung eines Bandpassfilter, dessen Durchlassbereich variabel eingestellt werden kann, eine einfache Analyse des Signals nach dem Auftreten von bestimmte Geräusche oder Signalworte repräsentierenden Signalmustern erfolgen. Hierbei wird lediglich das Auftreten von bestimmten vorbestimmten bzw. erwarteten spektralen Komponenten des Signals zu unterschiedlichen Zeitpunkten hin überprüft.

Besonders günstig ist eine Ausführungsform des hier vorgeschlagenen Ansatzes, bei der im wiederholt ausgeführten Schritt des Auswertens das Analog-Digital-Filtersignal dann unter Verwendung des weiteren Erwartungswertes ausgewertet wird, wenn im vorangegangenen Schritt des Auswertens das Analog-Digital-Filtersignal in einer vorbestimmten Beziehung zu dem Erwartungswert gestanden hat. Unter einer vorbestimmten Beziehung des Analog-Digital-Filtersignals zu dem Erwartungswert kann beispielsweise verstanden werden, dass ein Parameter des Analog-Digital-Filtersignals (der beispielsweise eine Amplitude oder eine Energie des Analog-Digital-Filtersignals repräsentiert) größer als der Erwartungswert ist oder innerhalb eines Toleranzbereichs von bispielsweise 20 Prozent um den Erwartungswert liegt. Eine Ausführungsform des hier vorgeschlagenen Ansatzes bietet den Vorteil, dass mit technisch einfachen Mitteln eine zeitliche Abfolge der zu erwartenden Signalanteilen in unterschiedlichen Frequenzbereichen verifiziert bzw. sichergestellt werden kann.

Weiterhin ist denkbar, dass nach einem ersten Durchlauf bei der Abarbeitung von Verfahrensschritten tatsächlich ein erwarteter spektraler Signalanteil im ersten Durchlassbereich erkannt wurde, jedoch in einem anschließenden Durchlauf der Abarbeitung von Verfahrensschritten nicht mehr ein spektraler Signalanteil erkannt wurde, der eigentlich bei der Erkennung eines bestimmten Geräuschs oder Signalworts hätte auftreten müsste. In diesem Fall kann gemäß einer weiteren Ausführungsform des hier vorgeschlagenen Ansatzes ein Zurücksetzen einer Steuereinheit bzw. des Bandpassfilters derart erfolgen, dass für die nachfolgende Verarbeitung des Signals wieder das Auftreten eines Signalanteils des Signals im ersten spektralen Durchlassbereich überprüft wird. Dies bedeutet, dass in einem solchen Fall das Bandpassfilter wieder dahingehend angesteuert wird, dass der Durchlass-Frequenzbereich des Bandpassfilters auf den ersten spektralen Durchlassbereich gesetzt wird. Gemäß einer solchen Ausführungsform des hier vorgestellten Ansatzes kann somit, wenn im Schritt des Auswertens das Analog-Digital-Filtersignal nicht in einer vorbestimmten Beziehung zu dem Erwartungswert gestanden hat, das Analog-Digital-Filtersignal im wiederholt ausgeführten Schritt des Auswertens unter Verwendung des (ursprünglichen) Erwartungswertes ausgewertet werden. Alternativ oder zusätzlich kann, wenn im wiederholt ausgeführten Schritt des Auswertens das Analog-Digital-Filtersignal nicht in einer vorbestimmten Beziehung zu dem weiteren Erwartungswert gestanden hat, in einem dem wiederholt ausgeführten Schritt des Auswertens nachfolgenden Schritt des Auswertens das Analog-Digital-Filtersignal unter Verwendung des Erwartungswertes ausgewertet werden.

Besonders präzise ist eine Analyse des Signals, wenn erfindungsgemäß parallel zu dem (ersten) Bandpassfilter noch ein zweites Bandpassfilter verwendet wird, welches das Auftreten von Signalanteilen in einem anderen Durchlass-Frequenzbereich auswertet, als das (erste) Bandpassfilter. Hierdurch lässt sich mit einer technisch ebenfalls einfachen Struktur, die nun zwei parallel arbeitende Bandpassfilter aufweist, eine deutliche Verbesserung der Analyse des Signals vornehmen, da neben den Signalanteilen des Signals aus dem ersten Durchlassbereich noch Signalanteilen Signals aus einem zweiten Durchlassbereich berücksichtigt werden können. Gemäß einer weiteren Ausführungsform des hier vorgeschlagenen Ansatzes kann somit im Schritt de Filterns das Signal unter Verwendung eines sich in Bezug auf einen Durchlass-Frequenzbereich von dem Bandpassfilter unterscheidenden weiteren Bandpassfilters gefiltert werden, um ein weiteres Bandpassfiltersignal zu erhalten. Im Schritt des Analog-Digital-Wandelns kann das weitere Bandpassfiltersignal oder eines von dem weiteren Bandpassfiltersignal abgeleitetes Signal analog-digital gewandelt werden, um ein weiteres Analog-Digital-Filtersignal zu erhalten und im Schritt des Auswertens kann das weitere Analog-Digital-Filtersignal unter Verwendung eines zweiten oder weiteren Erwartungswertes ausgewertet werden, um ein weiteres Steuersignal zu erhalten, wobei der weitere Erwartungswert einen erwarteten Signalparameter des Signals repräsentiert. Im Schritt des Ansteuerns kann das weitere Bandpassfilter insbesondere in Abhängigkeit von dem weiteren Steuersignal angesteuert werden, um einen Durchlass-Frequenzbereich des weiteren Bandpassfilters von einem dritten spektralen Durchlassbereich zu einem vierten spektralen Durchlassbereich zu verändern.

Gemäß der Erfindung werden im Schritt des Ansteuerns das Steuersignal und das weitere Steuersignal zu unterschiedlichen Zeitpunkten ausgegeben. Eine solche Ausführungsform des hier vorgestellten Ansatzes bietet den Vorteil, zeitlich unterschiedlich lange die Signalanteile im ersten Durchlassbereich und im zweiten Durchlassbereich auswerten zu können, sodass beispielsweise zumindest in unterschiedlichen Frequenzbereichen eine zeitliche Überlappung der Auswertung erfolgen kann. Dies ermöglicht eine deutlich höhere Flexibilität bei der Erkennung von vorbestimmten Geräuschen oder Signalworten bzw. Schlüsselworten im Signal.

Von Vorteil ist weiterhin eine Ausführungsform des hier vorgestellten Ansatzes, bei der im Schritt des Auswertens ein Erwartungswert verwendet wird, der aus einem Speicher abgerufen wird und der unter Verwendung zumindest eines Teils eines aufgezeichneten Aktusitk- und/oder Sprachsignals ermittelt wird, insbesondere wobei das aufgezeichnete Aktusitk- und/oder Sprachsignal eine akustische Repräsentation eines vordefinierten Geräusches, Signalwortes und/oder Schlüsselwortes abbildet. Solche Ausführungsform des hier vorgeschlagenen Ansatzes bietet den Vorteil, durch das aufgezeichnete Sprachsignal des vordefinierten Geräusches, Signalwortes und/oder Schlüsselwortes ein Training der Erkennung der akustischen Repräsentation dieses Wortes bzw. Geräusches vornehmen zu können, sodass eine sehr präzise Erkennung beziehungsweise Unterscheidung von bestimmten Signalworten, Schlüsselworten oder Geräuschen im hier vorgestellten Ansatz möglich wird.

Technisch besonders effizient ist eine Ausführungsform des hier vorgeschlagenen Verfahrens, bei der im Schritt des Filterns ein gm-C-Filter verwendet wird. Die Verwendung eines solchen Typs von Bandpassfilter ermöglicht den schnellen und einfachen Wechsel des Durchlass-Frequenzbereichs des angesteuerten Bandpassfilters.

Gemäß einer weiteren Ausführungsform des hier vorgeschlagenen Ansatzes kann im Schritt des Analog-digital-Wandelns das Bandpassfiltersignal gleichgerichtet und nachfolgend tiefpass-gefiltert werden, um das vom Bandpassfiltersignal abgeleitete Signal zu erhalten. Eine solche Ausführungsform bietet den Vorteil einer technisch einfachen Verarbeitungsmöglichkeit, da durch die vorstehend genannte Verarbeitungsmöglichkeit bereits die Energie der Signalanteile des Signals im Durchlassbereich des Bandpassfilters ermittelt wird und somit sowohl eine Analog-Digital-Wandlung als auch die Auswertung unter Verwendung des Erwartungswerts schaltungstechnisch bzw. numerisch deutlich vereinfacht werden kann.

Besonders vorteilhaft ist eine Ausführungsform des hier vorgeschlagenen Ansatzes, bei der im Schritt des Einlesens das Signal unter Verwendung eines Verstärkers verstärkt wird. Eine solche Ausführungsform bietet den Vorteil, auch bei nur sehr schwach empfangenen Signalanteilen noch eine hinreichende Signalgüte der Signalanteile in den zu untersuchenden spektralen Durchlassbereichen zu erreichen, sodass eine präzise und eindeutige Auswertung des Signals auf darin enthaltene Geräusche und/oder vorbestimmte Signalworte bzw. Schlüsselworte ermöglicht wird.

Vairanten des hier vorgestellten Verfahrens können beispielsweise in Software oder Hardware oder in einer Mischform aus Software und Hardware beispielsweise in einem Steuergerät implementiert sein.

Der hier vorgestellte Ansatz schafft ferner eine Vorrichtung, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Vorrichtung kann die der Erfindung zugrunde liegende Aufgabe schnell und effizient gelöst werden.

Hierzu kann die Vorrichtung zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Daten- oder Steuersignalen an den Aktor und/oder zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EEPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einer Vorrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Ausführungsbeispiele des hier vorgestellten Ansatzes sind in den Zeichnungen dargestellt und in der nachfolgenden Beschreibung näher erläutert. Es zeigt:
Fig. 1 zeigt ein Blockschaltbild einer Vorrichtung zum Verarbeiten eines Signals gemäß einem Ausführungsbeispiel;
Fig. 2 Diagramme eines beispielhaften Audiosignals und dessen Verlauf der Signalintensitäten innerhalb unterschiedlicher spektraler Bänder zur Erläuterung der hier vorgestellten Vorgehensweise;
Fig. 3 ein Diagramm eines Entscheidungsbaums zur Auswahl der Durchlass-Frequenzbereiche der Bandpassfilter gemäß einem Ausführungsbeispiel; und
Fig. 4 ein Ablaufdiagramm eines Verfahrens zum Verarbeiten eines Signals gemäß einem Ausführungsbeispiel.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

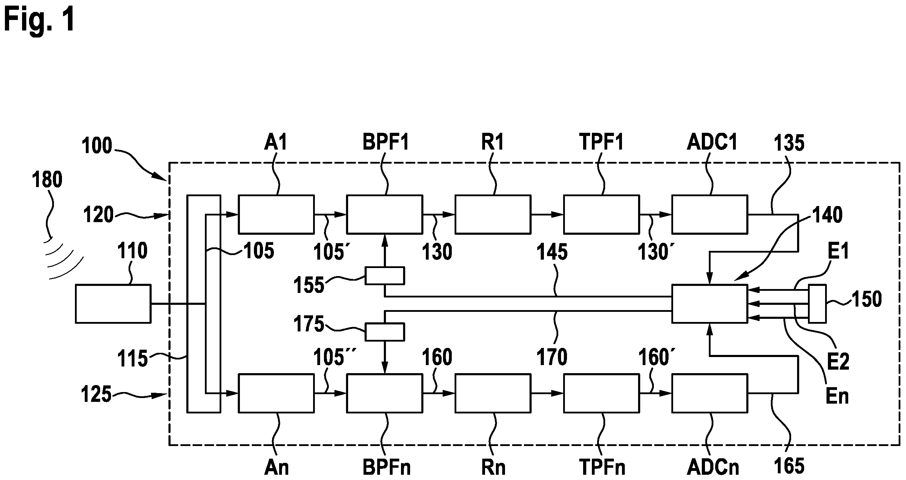

Figur 1 zeigt ein Blockschaltbild einer Vorrichtung 100 zum Verarbeiten eines Signals 105. Das Signal 105 wird beispielsweise von einem Signalgenerator 110 über eine Einleseschnittstelle 115 in die Vorrichtung 100 eingelesen. Der Signalgenerator 115 ist beispielsweise aus Mikrofon ausgebildet, um menschliche Sprache oder Geräusche aufzuzeichnen und in ein elektrisches Abbild zu verwandeln, welches das Signal 105 darstellt. Das Signal 105 wird in der beispielhaft dargestellten Vorrichtung 100 zum Verarbeiten nun in mehreren Verarbeitungszweigen 120 und 125 parallel verarbeitet, wobei die Verarbeitung in zwei parallelen Verarbeitungszweigen jedoch lediglich beispielhaft ausgewählt ist und auch eine Verarbeitung des Signals 105 in mehr als den in der Fig. 1 dargestellten beiden Verarbeitungszweigen 120 und 125 möglich ist. Im Folgenden soll zunächst die Verarbeitung des Signals 105 im ersten Verarbeitungszweig 120 näher beschrieben werden.

Das Signal 105 wird, nachdem ist über die Einleseschnittstelle 115 eingelesen wurde, einer optionalen Verstärkereinheit A1 zugeführt, in welcher das Signal 105 verstärkt wird und als verstärktes Signal 105' ausgegeben wird. Das verstärkte Signal 105' wird nachfolgend einem ersten Bandpassfilter BPF1 zugeführt, der ausgebildet ist, um Signalanteile des Signals 105 bzw. des verstärkten Signals 105' als Bandpassfiltersignal 130 auszugeben, die Frequenzen aufweisen, die in einem ersten spektralen Durchlassbereich liegen. Der erste spektrale Durchlassbereich kann sich beispielsweise durch eine Bandbreite BW1 um eine erste Durchlassmittenfrequenz fcl auszeichnen. Alle Signalanteile des Signals 105 bzw. des verstärkten Signals 105', die Frequenzen in dem ersten spektralen Durchlassbereich aufweisen, werden somit nahezu um gedämpft im Bandpassfiltersignal 130 enthalten sein, wogegen Signalanteile des Signals 105 bzw. des verstärkten Signals 105', die nicht im ersten spektralen Durchlassbereich liegen, gedämpft oder herausgefiltert werden. Das Bandpassfiltersignal 130 wird nun einem optionalen Gleichrichter R1 und anschließend einem optionalen ersten Tiefpassfilter TP1 zugeführt, um ein von dem Bandpassfiltersignal 130 abgeleitetes Signal 130' zu erhalten. Aus diesem von dem Bandpassfiltersignal 130 abgeleiteten Signal 130' sind somit Energien oder Intensitäten derjenigen Signalanteile des Signals 105 zu entnehmen, die das Signal 105 im ersten spektralen Durchlassbereich aufweist. Das Bandpassfiltersignal 130 bzw. das von dem Bandpassfiltersignal 130 abgeleitete Signal 130' wird nun unter Verwendung einer Analog-Digital-Wandlereinheit ADC1 analog-digital-gewandelt, um ein Analog-Digital-Filtersignal 135 zu erhalten. Das Analog-Digital-Filtersignal 135 wird in einer Auswertungseinheit 140 unter Verwendung eines Erwartungswert E1 verarbeitet, um ein Steuersignal 145 zu erhalten. Der Erwartungswert E1 repräsentiert hierbei einen erwarteten Signalparameter, den das Signal 105 aufweisen kann oder soll. Beispielsweise kann der Erwartungswert E1 einen Signalparameter oder eine Größe repräsentieren, die Signalanteilen des Signals 105 ersten spektralen Durchlassbereich entspricht, wenn das Signal 105 ein bestimmtes Schlüsselwort oder ein Geräusch darstellt, dessen Auftreten in dem Signal 105 überwacht werden soll. Hierzu kann der Erwartungswert E1 aus einem Speicher 150 abgerufen werden, in dem mehrere Erwartungswerte E1, E2, ... En abgespeichert sind, die jeweils einen anderen Signalparameter des Signals 105 in einem Signalteilabschnitt repräsentiert, wenn ein bestimmtes Schlüsselwort, Signalwort oder Geräusch in dem Signal 105 auftritt. Unter einem solchen Signalparameter kann beispielsweise das Auftreten eines Anteils des Signals 105 in einem bestimmten (bzw. den durch den ersten spektralen Durchlassbereich definierten) Frequenzbereich, eine Amplitude eines solchen Anteils des Signals 105 in einem (beispielsweise dem durch den ersten spektralen Durchlassbereich definierten) Frequenzbereich und/oder eine Energie eines solchen Anteils des Signals 105 in einem (beispielsweise dem durch den ersten spektralen Durchlassbereich definierten) Frequenzbereich verstanden werden. Insofern kann durch die Auswertungseinheit 140 ermittelt werden, ob ein bestimmter Signalanteil des Signals 105 einem vorgegebenen Kriterium entspricht. Eine solche Überprüfung kann beispielsweise in digitaler Form unter Verwendung eines digitalen Signalprozessors oder Mikrocontrollers erfolgen, der die Auswertungseinheit 140 bildet oder enthält. Beispielsweise kann eine solche Überprüfung durch den Vergleich des Erwartungswert E1 mit dem Analog-Digital-Filtersignal 135 oder eines davon abgeleiteten Signals erfolgen.

Ansprechend auf das Steuersignal 145 kann nun mittels einer ersten Steuereinheit 155 ein Durchlass-Frequenzbereich des ersten Bandpassfilters BPF1 verändert werden, sodass das erste Bandpassfiltersignal BPF1 nachfolgend nicht mehr Signalanteile des Signals 105 bzw. des verstärkten Signals 105' aus dem ersten spektralen Durchlassbereich ungedämpft passieren lässt, sondern Signalanteile aus einem von dem ersten spektralen Durchlassbereich unterschiedlichen zweiten spektralen Durchlassbereich. Auf diese Weise kann nun für einen nachfolgenden Ausführungszyklus der Schritte des hier vorgestellten Verfahrens bei der Verarbeitung des Signals 105 in der Auswertungseinheit 140 überprüft werden, ob nun auch Signalanteile des Signals 105 bzw. des verstärkten Signals 105' aus dem zweiten spektralen Durchlassbereich dem Erwartungswert E1 oder einem weiteren Erwartungswert E2, ... En entsprechen, sodass mit dem hier vorgeschlagenen Ansatzes eine zeitliche Abfolge von Überprüfungen vorgenommen werden kann, bestimmte Signalanteile im Signal 105 in entsprechender zeitlicher Abfolge vorliegen. Auf diese Weise kann mit einer sehr einfachen technologischen Struktur eine Überprüfung des Signals 105 auf das Vorliegen einer zeitlichen Abfolge von bestimmten erwarteten spektralen Komponenten in diesem Signal 105 vorliegt, sodass beispielsweise ein einfacher Rückschluss auf eine begrenzte Anzahl von in dem Signal 105 enthaltenen Signal-/Schlüsselwort in oder Geräuschen enthalten ist, die den verwendeten Erwartungswerten entsprechen.

Sollte eine Auswertung des Signals 105 unter Verwendung von lediglich einer spektralen Komponente, d. h., den Signalanteilen aus dem ersten spektralen Durchlassbereich des Bandpassfiltersignal BPF1 nicht hinreichend präzise für die Erkennung eines vorbestimmten Signal-/Schlüsselworts oder Geräusches in dem Signal 105 sein, kann das Signal 105 in weiteren Verarbeitungszweigen auf analoge Weise zu dem ersten Verarbeitungszweig 120 verarbeitet werden, von denen ohne Beschränkung der Allgemeinheit lediglich ein einziger weiterer Verarbeitungszweig 125 in der Figur 1 exemplarisch dargestellt ist. In diesem weiteren Verarbeitungszweig 125 wird das Signal 105 ebenfalls durch einen optionalen Verstärker An verstärkt, um ein weiteres verstärktes Signal 105" zu erhalten. Dieses weitere verstärktes Signal 105" wird einen weiteren Bandpassfilter BPFn zugeführt, welcher ein weiteres Bandpassfiltersignal 160 bereitstellt. Das weitere Bandpassfilter BPFn kann hierbei einen Durchlass-Frequenzbereich aufweisen, der sich mit einer weiteren Bandbreite BWn um eine weitere Bandpassfiltermittenfrequenz fcn erstreckt. Günstigerweise unterscheiden sich der weitere spektrale Durchlassbereich, auf den das weitere Bandpassfilter BPFn eingestellt ist, von dem ersten spektralen Durchlassbereich, sodass beispielsweise Signalanteile des Signals 105 einer Frequenz durch das erste Benadpassfilter BFP1 nicht passieren gelassen werden, diese Signalanteile jedoch von dem weiteren Bandpassfilter BPFn passieren gelassen werden.

Das weitere Bandpassfiltersignal 160 kann wiederum mit einem optionalen Gleichrichter Rn gleichgerichtet und anschließend mit einem weiteren Tiefpassfilter TPFn Tiefpass-gefiltert werden, um ein von dem weiteren Bandpassfiltersignal 160 abgeleitetes Signal 160' zu erhalten. Das weitere Bandpassfiltersignal 160 bzw. das davon abgeleitete Signal 160' wird nun mittels einer weiteren Analog-Digital-Wandlereinheit ADCn analog-digital-gewandelt, um ein weiteres Analog-Digital-Filtersignal 165 zu erhalten. dieses weitere Analog-Digital-Filtersignal 165 wird nun wiederum von der Auswertungseinheit 140 unter Verwendung eines Erwartungswerts wie beispielsweise einem zweiten Erwartungswert E2 oder einem weiteren Erwartungswert En ausgewertet, um ein weiteres Steuersignal 170 zu erhalten. Der Erwartungswert E2 bzw. En, der nun zur Auswertung des weiteren Analog-Digital-Filtersignals 165 verwendet wird, kann nun analog zu den vorstehenden Ausführungen ebenfalls einen erwarteten Signalparameter des Signals 105 repräsentieren, der nun Signalanteile des Signals 105 betrifft, die im Durchlass-Frequenzbereich des weiteren Bandpassfiltersignal BPFn liegen. Unter Verwendung des weiteren Steuersignals 170 kann nun mittels einer weiteren Steuereinheit 175 der weiteren Bandpassfilter BPFn derart angesteuert werden, das ein Durchlass-Frequenzbereich des weiteren Bandpassfilters BPFn vom weiteren spektralen Durchlassbereich zu dem ersten oder einem dritten spektralen Durchlassbereich verändert wird. Auf diese Weise können auch die Filtereigenschaften des weiteren Bandpassfilters BPFn für eine nachfolgende Verarbeitung des Signals 105 verändert werden, sodass auch mittels dieser Form eine zeitliche Abfolge von in dem Signal 105 auftretenden spektralen Komponenten ermittelt werden kann.

Vorteilhaft bei der Verwendung der Verarbeitung des Signals 105 in mehreren parallelen Verarbeitungszweigen ist die Tatsache, dass die Analyse des Signals 105 in unterschiedlichen Frequenzbereichen zeitgleich erfolgen kann. Zusätzlich ist es auch möglich, dass die Bandpassfilter unterschiedlich lange Zeitfenster erhalten, in denen sie jeweils das Signal 105 mit dem aktuell eingestellten spektralen Durchlassbereich filtern, so dass sich eine sehr flexible Auswertungsmöglichkeit der einzelnen spektralen Komponenten ergibt, die in dem Signal 105 auftreten. Dennoch kann die hier vorgestellte Struktur technisch sehr einfach umgesetzt werden und arbeitet ohne hohen Energiebedarf, so dass auch in autonomen und/oder mobilen Einheiten eine einfache Analyse von Signalen wie beispielsweise einem Audiosignal als Signal 105 problemlos ausgeführt werden kann.

Weiterhin kann auch in einem weiteren, in der Fig. 1 nicht explizit dargestellten Ausführungsbeispiels das weitere Steuersignal 170 von der Steuereinheit 155 zum Verändern des Durchlass-Frequenzbereichs des ersten Bandpassfilters BPF1 verwendet werden. Durch eine solche kreuzweise Kopplung lässt sich eine weitere Flexibilisierung der Analyse des Signals 105 erreichen.

Nach einer Detektion von entsprechenden Signalanteilen in dem Signal 105 durch einen hier beschriebenen Ansatz kann nun das Vorliegen eines Schlüsselwortes oder eines Geräusches in diesem Signal 105 erkannt werden und diese Information für weitere Zwecke, die nicht Teil der vorliegenden Erfindung sind und somit nicht weiter beschrieben werden, genutzt werden.

Prinzipiell kann somit ein Aspekt des hier vorgestellten Ansatzes darin gesehen werden, eine Realisierung der Analyse von Signalen mit einer reduzierten Anzahl von Filtern und somit mit reduzierter Chipfläche und noch geringerem Stromverbrauch bei dem Betrieb einer solchen Vorrichtung 100 zu ermöglichen. Als ein wichtiger Aspekt bei der Realisierung kann die Verwendung von einstellbaren Filtern und eine Steuerung zur Nachführung der jeweiligen Zentralfrequenzen und Filterbandbreiten zu unterschiedlichen Zeitpunkten gesehen werden. Hierbei kann speziell darauf abgestellt werden, dass ein erwarteter Signalparameter in dem Signal auch tatsächlich aufgetreten ist und somit ein Hinweis darauf vorliegt, dass ein bestimmtes Schlüssel- oder Signalwort bzw. Geräusch in dem als Audiosignal eingelesenen Signal 105 enthalten ist. Der hier vorgestellte Ansatz bietet dabei den Vorteil, dass eine Reduzierung der Anzahl der (Bandpass-) Filter zu einer kleineren Chipfläche und zu weniger Stromaufnahme als im Stand der Technik führt.

Fig. 1 zeigt in diesem Zusammenhang ein Blockschaltbild des Aufbaus der erfindungsgemäßen Umsetzung einer analogen Feature Extraktion gemäß einem Ausführungsbeispiel. Ein Schallsignal 180 (das auch als Akustik- und/oder Sprachsignal bezeichnet werden kann) wird durch ein analoges Mikrofon als Signalgenerator 110 aufgenommen, optional mit einem Verstärker A1 oder An verstärkt. Das Signal 105 bzw. 105' oder 105" wird anschließend je einem mehreren einstellbaren Bandpassfiltern BPF1, BPFn zugeführt. Das gefilterte Signal 130 bzw. 160 wird gleichgerichtet und mit einem Tiefpassfilter geglättet. Das geglättete Signal 130' 160' wird mit Analog-Digital-Umsetzern ADC1, ADCn digitalisiert und von einer Auswerteeinheit 140 analysiert, wobei dann ein Steuersignal 145 bzw. ein weiteres Steuersignal 170 ausgegeben wird, welches unter Verwendung der Steuereinheit 155 zur Steuerung des Durchlass-Frequenzbereichs des ersten Bandpassfilters BPF1 oder unter Verwendung der Steuereinheit 175 zur Steuerung des Durchlass-Frequenzbereichs des weiteren Bandpassfilters BPFn verwendet wird.

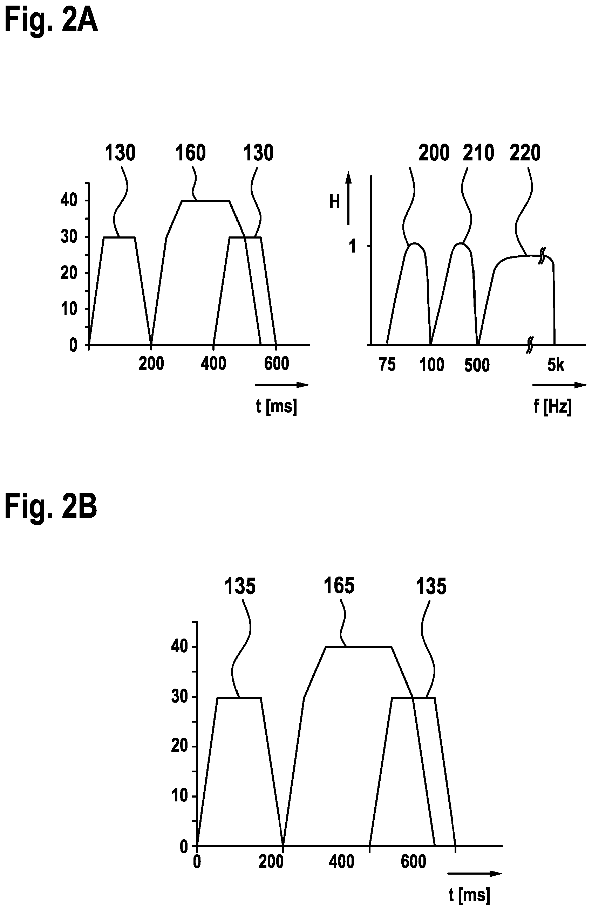

Fig. 2 zeigt Diagramme eines beispielhaften Audiosignals und dessen Verlauf der Signalintensitäten innerhalb unterschiedlicher spektraler Bänder 200, 210 und 220. In dem linken Diagramm aus der Fig. 2A ist hierbei auf der Abszisse die Zeit in ms und auf der Ordinate ein Signalparameter wie beispielsweise eine Intensität des Signals zu den betreffenden Zeitpunkten aufgetragen. In dem rechten Diagramm der Fig. 2A ist auf der Abszisse die Frequenz f und auf der Ordinate einer Übertragungsfunktion H bzw. die inverse Dämpfung der Bandpassfilter BPF1, BPFn bei einer Einstellung eines betreffenden Durchlass-Frequenzbereichs des betreffenden Bandpassfilters dargestellt. Dabei kann das erste spektrale Band 200 als der Bereich zwischen 75 bis 100 Hz, das zweite Band 210 als 100 bis 500 Hz und das dritte Band 220 als 500 bis 5kHz definiert sein. Ein Keyword (Schlüsselwort) oder ein Schallsignal in dem Signal 105 unterliegt in der Regel einem spezifischen Verlauf der Signalintensitäten in bestimmten spektralen Bändern. Die vorgestellte Umsetzung des hier vorgestellten Konzepts sieht vor, dass zum Zeitpunkt t=0 der erste Bandpassfilter BPF1 auf den Durchlass-Frequenzbereich des ersten Bandes 200 (75 bis 100 Hz als erstem spektralen Durchlassbereich) eingestellt ist. Folglich kann die erste Analog-Digital-Wandlereinheit der ADC1 in der Zeitspanne von t=0 bis 200 ms ein Signal 135 aufzeichnen, wie es im linken Teil des Diagramms aus Fig. 2B dargestellt ist. In dem Diagramm aus der Fig. 2B wird wiederum auf der Abszisse die Zeit in ms und auf der Ordinate der Signalparameter, hier beispielsweise als Signalintensität, aufgetragen. Der weiteren Bandpassfilter BPFn ist beispielsweise auf den Bereich des zweiten Bandes 210 (d. h., 100 bis 500 Hz als Durchlass-Frequenzbereich bzw. als dritten spektralen Durchlassbereich) eingestellt. Somit kann die weitere Analog-Digital-Wandlereinheit ADCn die Signalintensität im zweiten Band 210 zwischen t=200 und 550 ms aufzeichnen. Zum Zeitpunkt t=200 ms wird der erste Bandpassfilter BPF1 auf den spektralen Bereich des dritten Bands 220 (als zweitem spektralen Durchlassbereich) abgestimmt. Somit kann der erste Analog-Digital-Wandler ADC1 die Signalintensität im dritten Band 220 zwischen t=400 und 600 ms aufzeichnen. Die Rekonstruktion des ursprünglichen Signalintensitätsverlaufs anhand der zwei Datenströme (d. h., den Daten aus der ersten Analog-Digital-Wandlereinheit ADC1 und der weiteren Analog-Digital-Wandlereinheit ADC2) ist aufgrund des bekannten Wissens über die zum Zeitpunkt t eingestellten Filtercharakteristiken einfach möglich.

Das Umschalten bzw. der Frequenzabgleich der Filter wird von der Steuereinheit 155 bzw. der weiteren Steuereinheit 175 gesteuert. Hierzu kann im einfachsten Fall ein Entscheidungsbaum eingesetzt werden.

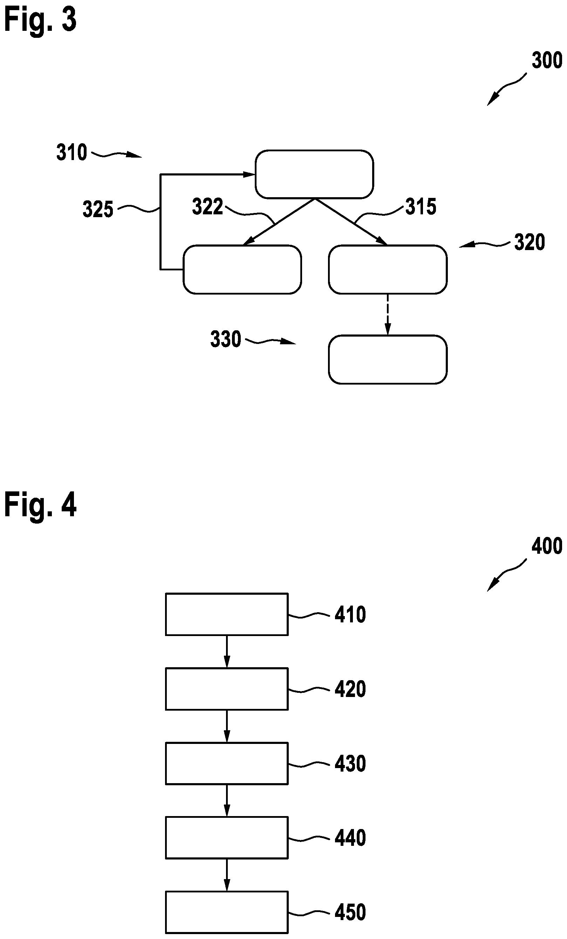

Fig. 3 zeigt ein Diagramm eines solchen Entscheidungsbaums 300 zur Auswahl der Durchlass-Frequenzbereiche der Bandpassfilter BPF gemäß einem Ausführungsbeispiel. Konkret wird in einem ersten Zustand 310 ein sogenannter "Feature Vektor" (hier ein Vektor der digitalisierten Werte der Signalintensitäten, also des für den jeweils betrachteten Verarbeitungszweig vorliegenden Analog-Digital-Filtersignals 135 bzw. 165) mit je einem Erwartungswert E1, E2, ... En zeitkontinuierlich oder an diskreten Zeitpunkten verglichen. Beispielsweise wird zu einem ersten Zeitpunkt tl das Analog-Digital-Filtersignal 135 mit dem Erwartungswert En zu diesem Zeitpunkt tl, also beispielsweise E1(t1)), vergleichen. Der Bandpassfilter ist in diesem Fall so eingestellt, dass Signalanteile des Signals 105 im ersten spektralen Durchlassbereich den Bandpassfilter 130 passieren können, der Bandpassfilter BPF1 wird in diesem Fall also im ersten zustand betrieben). Wenn die Übereinstimmung zwischen diesen beiden Werten (d. h., Erwartungswert und Analog-Digital-Filtersignal) jeweils positiv beschieden wird (Pfad 315), wird das Bandpassfilter BPFn des jeweiligen Verarbeitungszweigs in den nächsten Zustand 320 (auch "State" genannt) geschaltet, bei dem beispielsweise im ersten Verarbeitungszweig der Durchlass-Frequenzbereich des ersten Bandpassfilters BPF1 in dem zweiten spektralen Durchlassbereich geschaltet wird. Wenn der Vergleich nicht positiv ist (d. h., wenn der Erwartungswert nicht innerhalb eines Toleranzbereichs dem Analog-Digital-Filtersignal entspricht) (Pfad 322), fällt das System in den Ausgangszustand 310 (State 1) zurück, d. h. beim Bandpassfilter BPF1 wird der Durchlass-Frequenzbereich wieder auf den ersten spektralen Durchlassbereich gesetzt (Pfad 325) verändert. Diese Vorgehensweise wird für weitere Zustände 330 wie den Zustand n wiederholt, bis eine positive Erkennung des durch die Erwartungswerte in den unterschiedlichen Frequenzbereichen repräsentierten Geräusches bzw. Signal-/Schlüsselwortes in dem Signal 105 beschieden wird.

Besonders günstig lassen sich die hier genannten, allgemein als nicht trivial geltenden Filter dann implementieren, wenn für den Zweck der Schallereignisanalyse sogenannte gm-C Filter als Bandpassfilter BPF zum Einsatz in dem hier beschriebenen Ansatz verwendt werden. Dabei handelt es sich um eine Art von Filtern, deren Grundzelle auf spannungsgesteuerten Stromquellen und Kapazitäten basiert. Durch Wahl der Verstärkungsfaktoren und Dimensionierung der Kapazitäten kann die Filtercharakteristik eingestellt werden. Anders als die Kapazitätswerte ist die Anpassung der Verstärkungsfaktoren zur Laufzeit einfach möglich. Eine spannungsgesteuerte Stromquelle kann im einfachsten Fall aus einem einzelnen Transistor bestehen. Der Einstellung des Gleichstromarbeitspunkts kann der Verstärkungsfaktor (Steilheit) eingestellt werden.

Der hier vorgestellte Ansatz bietet den Vorteil, dass die Verwendung von einstellbaren (Bandpass-) Filtern die Reduzierung der Anzahl der Analog-digital-Wandlereinheiten und der Anzahl der Filter ermöglicht. Daraus resultiert eine kleinere Chipfläche beim Aufbau der hier vorgestellten Struktur in einer integrierten Schaltung. Aus einer kleineren Anzahl von betriebenen Komponenten in einer integrierten Schaltung resultiert in der Regel auch ein geringerer Stromverbrauch. Das Maß der möglichen Verkleinerung hängt von der Anzahl der relevanten Frequenzbänder und dem Maß der Parallelität der Signalintensität in den Bändern ab. Typischer Weise wird eine Reduzierung um 50% erwartet.

Der hier vorgestellte Ansatz kann alleinstehend oder integriert in ein Mikrofon eingesetzt werden. Die Anforderung an sehr geringe Kosten und sehr geringem Stromverbrauch ist typischer Weise bei in Smartphones und Geräten des Internet of Things anzutreffen.

Fig. 4 zeigt ein Ablaufdiagramm eines Verfahrens 400 zum Verarbeiten eines Signals gemäß einem Ausführungsbeispiel. Das Verfahren 400 umfasst einen Schritt 410 des Einlesens des Signals und einen Schritt 420 des Filterns des Signals unter Verwendung eines Bandpassfilters, um ein Bandpassfiltersignal zu erhalten. Ferner umfasst das Verfahren 400 einen Schritt 430 des Analog-Digital-Wandelns des Bandpassfiltersignals oder eines von dem Bandpassfiltersignal abgeleiteten Signals, um ein Analog-Digital-Filtersignal zu erhalten. Auch umfasst das Verfahren 400 einen Schritt 440 des Auswertens des Analog-Digital-Filtersignal unter Verwendung eines Erwartungswertes, um ein Steuersignal zu erhalten, wobei der Erwartungswert einen erwarteten Signalparameter des Signals repräsentiert. Schließlich umfasst das Verfahren 400 einen Schritt 450 des Ansteuerns des Bandpassfilters in Abhängigkeit von dem Steuersignal, um einen Durchlass-Frequenzbereich des Bandpassfilters von einem ersten spektralen Durchlassbereich zu einem zweiten spektralen Durchlassbereich zu verändern.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (400) zum Verarbeiten eines Audiosignals (105, 105'), wobei das Verfahren (400) die folgenden Schritte aufweist:
- Einlesen (410) des Audiosignals (105, 105'),
- Filtern (420) des Audiosignals (105, 105') unter Verwendung eines Bandpassfilters (BPF1) um ein Bandpassfiltersignal (130) zu erhalten;
- Analog-Digital-Wandeln (430) des Bandpassfiltersignals (130) oder eines von dem Bandpassfiltersignal (130) abgeleiteten Audiosignals (130'), um ein Analog-Digital-Filtersignal (135) zu erhalten;
- Auswerten (440) des Analog-Digital-Filtersignal (135) unter Verwendung eines Erwartungswertes (E1), um ein Steuersignal (145) zu erhalten, wobei der Erwartungswert (E1) einen erwarteten Signalparameter des Audiosignals (105) repräsentiert; und
- Ansteuern (450) des Bandpassfilters (BPF1) in Abhängigkeit von dem Steuersignal (145), um einen Durchlass-Frequenzbereich des Bandpassfilters (BPF1) von einem ersten spektralen Durchlassbereich (200) zu einem zweiten spektralen Durchlassbereich (220) zu verändern,
**wobei**
- im Schritt des Filterns (420) das Signal unter Verwendung eines sich in Bezug auf einen Durchlass-Frequenzbereich von dem Bandpassfilter (BPF1) unterscheidenden weiteren Bandpassfilters (BPFn) gefiltert wird, um ein weiteres Bandpassfiltersignal (160) zu erhalten, wobei die Bandpassfilter (BPF1, BPFn) unterschiedlich lange Zeitfenster aufweisen und
- im Schritt des Analog-Digital-Wandelns das weitere Bandpassfiltersignal (160) oder eines von dem weiteren Bandpassfiltersignal (160) abgeleitetes Signal (160') analog-digital gewandelt wird, um ein weiteres Analog-Digital-Filtersignal (165) zu erhalten und
- im Schritt des Auswertens (440) das weitere Analog-Digital-Filtersignal (165) unter Verwendung eines weiteren Erwartungswertes (E2, En) ausgewertet wird, um ein weiteres Steuersignal (175) zu erhalten, insbesondere wobei der weitere Erwartungswert (E2, En) einen erwarteten Signalparameter des Audiosignals (105) repräsentiert und
- im Schritt des Ansteuerns (450) das weitere Bandpassfilter (BPFn) in Abhängigkeit von dem weiteren Steuersignal (175) angesteuert wird, um einen Durchlass-Frequenzbereich des weiteren Bandpassfilters (BPFn) von einem dritten spektralen Durchlassbereich (210) zu einem vierten spektralen Durchlassbereich zu verändern, wobei das Steuersignal (145) und das weitere Steuersignal (175) zu unterschiedlichen Zeitpunkten ausgegeben werden.

2. Verfahren (400) gemäß Anspruch 1, **dadurch gekennzeichnet, dass** im Schritt des Auswertens als Erwartungswert (E1) ein Wert verwendet wird, der eine Signalintensität des Audiosignals (105) im ersten spektralen Durchlassbereich (200) repräsentiert.

3. Verfahren (400) gemäß einem der vorangegangenen Ansprüche, **dadurch gekennzeichnet, dass** im Schritt des Ansteuerns (450) der Durchlass-Frequenzbereich des Bandpassfilters (BPF1) nicht verändert wird, wenn im Schritt des Auswertens (440) ermittelt wurde, dass das Analog-Digital-Filtersignal (135) nicht in einer vorbestimmten Beziehung zu dem Erwartungswert (E1) steht.

4. Verfahren (400) gemäß einem der vorangegangenen Ansprüche, **dadurch gekennzeichnet, dass** die Schritte des Einlesens (410), Filterns (420), Analog-digital-Wandelns (430), Auswertens (440) und Ansteuerns (450) wiederholt ausgeführt werden, wobei im wiederholt ausgeführten Schritt des Auswertens (440) das Analog-Digital-Filtersignal (135) zum Erhalt eines weiteren Steuersignals (145) unter Verwendung eines weiteren Erwartungswertes (E2, En) ausgewertet wird, der sich vom Erwartungswert (E1) unterscheidet und der einen
erwarteten Signalparameter des Audiosignals (105) repräsentiert, insbesondere wobei im wiederholt ausgeführten Schritt des Ansteuerns (450) der Bandpassfilter (BPF1) in Abhängigkeit von dem weiteren Steuersignal (145) angesteuert wird, um den Durchlass-Frequenzbereich des Bandpassfilters (BPF1) von dem zweiten spektralen Durchlassbereich (220) zu dem ersten (200) oder einem dritten spektralen Durchlassbereich (210) zu verändern.

5. Verfahren (400) gemäß Anspruch 4, **dadurch gekennzeichnet, dass** im wiederholt ausgeführten Schritt des Auswertens (440) das Analog-Digital-Filtersignal (135) dann unter Verwendung des weiteren Erwartungswertes (E2, En) ausgewertet wird, wenn im vorangegangenen Schritt des Auswertens (440) das Analog-Digital-Filtersignal (135) in einer vorbestimmten Beziehung zu dem Erwartungswert (E1) gestanden hat.

6. Verfahren (400) gemäß Anspruch 4 oder 5, **dadurch gekennzeichnet, dass,** wenn im Schritt des Auswertens (440) das Analog-Digital-Filtersignal (135, 165) nicht in einer vorbestimmten Beziehung zu dem Erwartungswert (E1) gestanden hat, das Analog-Digital-Filtersignal (135) im wiederholt ausgeführten Schritt des Auswertens unter Verwendung des Erwartungswertes (E1) ausgewertet wird, oder,
wenn im wiederholt ausgeführten Schritt des Auswertens (440) das Analog-Digital-Filtersignal (135) nicht in einer vorbestimmten Beziehung zu dem weiteren Erwartungswert (E2, En) gestanden hat, in einem dem wiederholt ausgeführten Schritt des Auswertens (440) nachfolgenden Schritt des Auswertens (440) das Analog-Digital-Filtersignal (135) unter Verwendung des Erwartungswertes (E1) ausgewertet wird.

7. Verfahren (400) gemäß einem der vorangegangenen Ansprüche,
**dadurch gekennzeichnet, dass** im Schritt des Auswertens (440) ein Erwartungswert (E1, E2, En) verwendet wird, der aus einem Speicher (150) abgerufen wird und der unter Verwendung zumindest eines Teils eines aufgezeichneten Akustik- und/oder Sprachsignals (180) ermittelt wird, insbesondere wobei das aufgezeichnete Akustik- und/oder Sprachsignal (180) eine akustische Repräsentation eines vordefinierten Signalwortes oder eines Geräusches abbildet.

8. Verfahren (400) gemäß einem der vorangegangenen Ansprüche,
**dadurch gekennzeichnet, dass** im Schritt des Filterns (420) ein gm-C-Filter verwendet wird.

9. Verfahren (400) gemäß einem der vorangegangenen Ansprüche,
**dadurch gekennzeichnet, dass** im Schritt des Analog-Digital-Wandelns (430) das Bandpassfiltersignal (130) gleichgerichtet und nachfolgend Tiefpass-gefiltert wird, um das vom Bandpassfiltersignal (130) abgeleitete Signal (130') zu erhalten.

10. Verfahren (400) gemäß einem der vorangegangenen Ansprüche,
**dadurch gekennzeichnet, dass** im Schritt des Einlesens (410) das Audiosignal (105, 105') unter Verwendung eines Verstärkers (A1, An) verstärkt wird.

11. Vorrichtung (100), die eingerichtet ist, um die Schritte des Verfahrens (400) gemäß einem der vorangegangenen Ansprüche in entsprechenden Einheiten (115, A1, An, BPF1, BPFn, R1, Rn, TPF1, TPFn, ADC1, ADCn, 140, 155, 175) auszuführen und/oder anzusteuern.

12. Computerprogramm, das dazu eingerichtet ist, das Verfahren (400) gemäß einem der Ansprüche 1 bis 10 auszuführen und/oder anzusteuern.

13. Maschinenlesbares Speichermedium, auf dem das Computerprogramm nach Anspruch 12 gespeichert ist.

## Claims

1. Method (400) for processing an audio signal (105, 105'), wherein the method (400) comprises the following steps:
- reading in (410) the audio signal (105, 105'),
- filtering (420) the audio signal (105, 105') using a bandpass filter (BPF1) in order to obtain a bandpass filter signal (130);
- performing analogue-to-digital conversion (430) of the bandpass filter signal (130) or of an audio signal (130') derived from the bandpass filter signal (130) in order to obtain an analogue-to-digital filter signal (135);
- evaluating (440) the analogue-to-digital filter signal (135) using an expected value (E1) in order to obtain a control signal (145), wherein the expected value (E1) represents an expected signal parameter of the audio signal (105); and
- driving (450) the bandpass filter (BPF1) on the basis of the control signal (145) in order to change a frequency passband of the bandpass filter (BPF1) from a first spectral passband (200) to a second spectral passband (220),
**characterized in that**,
- in the filtering (420) step, the signal is filtered using a further bandpass filter (BPFn) that differs from the bandpass filter (BPF1) in terms of a frequency passband in order to obtain a further bandpass filter signal (160), wherein the bandpass filters (BPF1, BPFn) obtain time windows of different lengths, and,
- in the step of performing analogue-to-digital conversion, the further bandpass filter signal (160) or a signal (160') derived from the further bandpass filter signal (160) is converted from analogue to digital in order to obtain a further analogue-to-digital filter signal (165), and,
- in the evaluation (440) step, the further analogue-to-digital filter signal (165) is evaluated using a further expected value (E2, En) in order to obtain a further control signal (175), wherein the further expected value (E2, En) represents an expected signal parameter of the audio signal (105), and,
- in the driving (450) step, the further bandpass filter (BPFn) is driven on the basis of the further control signal (175) in order to change a frequency passband of the further bandpass filter (BPFn) from a third spectral passband (210) to a fourth spectral passband, wherein the control signal (145) and the further control signal (175) are output at different times.

2. Method (400) according to Claim 1, **characterized in that,** in the evaluation step, a value that represents a signal intensity of the audio signal (105) in the first spectral passband (200) is used as the expected value (E1) .

3. Method (400) according to either of the preceding claims, **characterized in that,** in the driving (450) step, the frequency passband of the bandpass filter (BPF1) is not changed if it was determined, in the evaluation (440) step, that the analogue-to-digital filter signal (135) does not have a predetermined correlation with the expected value (E1).

4. Method (400) according to one of the preceding claims, **characterized in that** the steps of reading-in (410), filtering (420), performing analogue-to-digital conversion (430), evaluation (440) and driving (450) are performed repeatedly, wherein, in the repeatedly performed evaluation (440) step, the analogue-to-digital filter signal (135) is evaluated in order to obtain a further control signal (145) using a further expected value (E2, En) that differs from the expected value (E1) and that represents an expected signal parameter of the audio signal (105), in particular wherein, in the repeatedly performed driving (450) step, the bandpass filter (BPF1) is driven on the basis of the further control signal (145) in order to change the frequency passband of the bandpass filter (BPF1) from the second spectral passband (220) to the first (200) or a third spectral passband (210).

5. Method (400) according to Claim 4, **characterized in that,** in the repeatedly performed evaluation (440) step, the analogue-to-digital filter signal (135) is evaluated using the further expected value (E2, En) when, in the preceding evaluation (440) step, the analogue-to-digital filter signal (135) had a predetermined correlation with the expected value (E1).

6. Method (400) according to Claim 4 or 5, **characterized in that,** if, in the evaluation (440) step, the analogue-to-digital filter signal (135, 165) did not have a predetermined correlation with the expected value (E1), the analogue-to-digital filter signal (135) is evaluated in the repeatedly performed evaluation step using the expected value (E1), or if, in the repeatedly performed evaluation (440) step, the analogue-to-digital filter signal (135) did not have a predetermined correlation with the further expected value (E2, En), the analogue-to-digital filter signal (135) is evaluated using the expected value (E1) in an evaluation (440) step following the repeatedly performed evaluation (440) step.

7. Method (400) according to one of the preceding claims, **characterized in that,** in the evaluation (440) step, an expected value (E1, E2, En) that is retrieved from a memory (150) and that is determined using at least part of a recorded acoustic and/or speech signal (180) is used, in particular wherein the recorded acoustic and/or speech signal (180) replicates an acoustic representation of a predefined signal word or a noise.

8. Method (400) according to one of the preceding claims, **characterized in that** a gm-C filter is used in the filtering (420) step.

9. Method (400) according to one of the preceding claims, **characterized in that,** in the step of performing analogue-to-digital conversion (430), the bandpass filter signal (130) is rectified and then low-pass filtered in order to obtain the signal (130') derived from the bandpass filter signal (130).

10. Method (400) according to one of the preceding claims, **characterized in that,** in the reading-in (410) step, the audio signal (105, 105') is amplified using an amplifier (A1, An).

11. Device (100) configured to perform and/or to drive the steps of the method (400) according to one of the preceding claims in corresponding units (115, A1, An, BPF1, BPFn, R1, Rn, TPF1, TPFn, ADC1, ADCn, 140, 155, 175) .

12. Computer program configured to perform and/or to drive the method (400) according to one of Claims 1 to 10.

13. Machine-readable storage medium on which the computer program according to Claim 12 is stored.

## Revendications

1. Procédé (400) de traitement d'un signal audio (105, 105'), le procédé (400) présentant les étapes suivantes consistant à :
- lire (410) le signal audio (105, 105'),
- filtrer (420) le signal audio (105, 105') en utilisant un filtre passe-bande (BPF1) afin d'obtenir un signal de filtre passe-bande (130) ;
- appliquer une conversion analogique/numérique (430) au signal de filtre passe-bande (130) ou à un signal audio (130') dérivé du signal de filtre passe-bande (130) afin d'obtenir un signal de filtre analogique/numérique (135) ;
- évaluer (440) le signal de filtre analogique/numérique (135) en utilisant une valeur attendue (E1) afin d'obtenir un signal de commande (145), la valeur attendue (E1) représentant un paramètre de signal attendu du signal audio (105) ; et
- piloter (450) le filtre passe-bande (BPF1) en fonction du signal de commande (145) afin de modifier une plage de fréquences de passage du filtre passe-bande (BPF1) d'une première plage de passage spectrale (200) en une deuxième plage de passage spectrale (220), **caractérisé en ce que**
- à l'étape de filtrage (420), le signal est filtré en utilisant un filtre passe-bande supplémentaire (BPFn) différent du filtre passe-bande (BPF1) au niveau d'une plage de fréquences de passage afin d'obtenir un signal de filtre passe-bande supplémentaire (160), les filtres passe-bande (BPF1, BPFn) recevant des fenêtres de temps de durée différente, et
- à l'étape de conversion analogique/numérique, le signal de filtre passe-bande supplémentaire (160) ou un signal (160') dérivé du signal de filtre passe-bande supplémentaire (160) est soumis à une conversion analogique/numérique afin d'obtenir un signal de filtre analogique/numérique supplémentaire (165), et
- à l'étape de l'évaluation (440), le signal de filtre analogique/numérique supplémentaire (165) est évalué en utilisant une valeur attendue supplémentaire (E2, En) afin d'obtenir un signal de commande supplémentaire (175), la valeur attendue supplémentaire (E2, En) représentant un paramètre de signal attendu du signal audio (105), et
- à l'étape de pilotage (450), le filtre passe-bande supplémentaire (BPFn) est piloté en fonction du signal de commande supplémentaire (175) afin de modifier une plage de fréquences de passage du filtre passe-bande supplémentaire (BPFn) d'une troisième plage de passage spectrale (210) en une quatrième plage de passage spectrale, le signal de commande (145) et le signal de commande supplémentaire (175) étant délivrés à différents instants.

2. Procédé (400) selon la revendication 1, **caractérisé en ce qu'**à l'étape d'évaluation, comme valeur attendue (E1), une valeur est utilisée qui représente une intensité de signal du signal audio (105) dans la première plage de passage spectrale (200) .

3. Procédé (400) selon l'une quelconque des revendications précédentes, **caractérisé en ce qu'**à l'étape de pilotage (450), la plage de fréquences de passage du filtre passe-bande (BPF1) n'est pas modifiée si à l'étape d'évaluation (440), il a été déterminé que le signal de filtre analogique/numérique (135) ne se trouve dans une relation prédéterminée avec la valeur attendue (E1).

4. Procédé (400) selon l'une quelconque des revendications précédentes, **caractérisé en ce que** les étapes de lecture (410), de filtrage (420), de conversion analogique/numérique (430), d'évaluation (440) et de pilotage (450) sont effectuées à plusieurs reprises, dans lequel, à l'étape d'évaluation (440) effectuée à plusieurs reprises, le signal de filtre analogique/numérique (135) pour l'obtention d'un signal de commande supplémentaire (145) est évalué en utilisant une valeur attendue supplémentaire (E2, En) qui est différente de la valeur attendue (E1) et qui représente un paramètre de signal du signal audio attendu (105), en particulier dans lequel, à l'étape de pilotage (450) effectuée à plusieurs reprises, le filtre passe-bande (BPF1) est piloté en fonction du signal de commande supplémentaire (145) afin de modifier la plage de fréquences de passage du filtre passe-bande (BPF1) de la deuxième plage de passage spectrale (220) en la première (200) ou une troisième plage de passage spectrale (210).

5. Procédé (400) selon la revendication 4, **caractérisé en ce qu'**à l'étape d'évaluation (440) effectuée à plusieurs reprises, le signal de filtre analogique/numérique (135) est alors évalué en utilisant la valeur attendue supplémentaire (E2, En) si à l'étape d'évaluation (440) précédente, le signal de filtre analogique/numérique (135) s'est trouvé dans une relation prédéterminée avec la valeur attendue (E1).

6. Procédé (400) selon la revendication 4 ou 5, **caractérisé en ce que**, si à l'étape d'évaluation (440), le signal de filtre analogique/numérique (135, 165) ne s'est pas trouvé dans une relation prédéterminée avec la valeur attendue (E1), le signal de filtre analogique/numérique (135) est évalué à l'étape d'évaluation effectuée à plusieurs reprises en utilisant la valeur attendue (E1), ou si à l'étape d'évaluation (440) effectuée à plusieurs reprises, le signal de filtre analogique/numérique (135) ne s'est pas trouvé dans une relation prédéterminée avec la valeur attendue supplémentaire (E2, En), dans une étape d'évaluation (440) suivant l'étape d'évaluation (440) effectuée à plusieurs reprises, le signal de filtre analogique/numérique (135) est évalué en utilisant la valeur attendue (E1).

7. Procédé (400) selon l'une quelconque des revendications précédentes, **caractérisé en ce que** à l'étape d'évaluation (440), une valeur attendue (E1, E2, En) est utilisée qui est extraite d'une mémoire (150) et qui est déterminée en utilisant au moins une partie d'un signal acoustique et/ou vocal (180) enregistré, en particulier dans lequel le signal acoustique et/ou vocal (180) reproduit une représentation acoustique d'un mot-clé prédéfini ou d'un bruit.

8. Procédé (400) selon l'une quelconque des revendications précédentes, **caractérisé en ce qu'**à l'étape de filtrage (420), un filtre Gm-C est utilisé.

9. Procédé (400) selon l'une quelconque des revendications précédentes, **caractérisé en ce qu'**à l'étape de conversion analogique/numérique (430), le signal de filtre passe-bande (130) est redressé et ensuite filtré passe-bas afin d'obtenir le signal (130') dérivé du signal de filtre passe-bande (130).

10. Procédé (400) selon l'une quelconque des revendications précédentes, **caractérisé en ce qu'**à l'étape de lecture (410), le signal audio (105, 105') est amplifié en utilisant un amplificateur (A1, An).

11. Dispositif (100) qui est aménagé pour exécuter et/ou piloter les étapes du procédé (400) selon l'une quelconque des revendications précédentes dans des unités correspondantes (115, A1, An, BPF1, BPFn, R1, Rn, TPF1, TPFn, ADC1, ADCn, 140, 155, 175).

12. Programme informatique qui est aménagé pour exécuter et/ou piloter le procédé (400) selon l'une quelconque des revendications 1 à 10.

13. Support de mémoire lisible par machine sur lequel est stocké le programme informatique selon la revendication 12.
